# DEMANDE DE BREVET EUROPEEN

(11) **EP 1 603 376 A1**
(43) Date de publication de la demande: **07.12.2005**
(21) Numéro de dépôt: 05291187.2
(22) Date de dépôt: 02.06.2005
(51) Int. Cl.: H05K 3/44, H05K 1/02

(54) **Circuit imprimé à dépôt sélectif**

(30) Priorité: 03.06.2004 FR 0451098
(71) Demandeur: BREE (Beauce Réalisations et Études Électroniques), 45300 Pithiviers (FR)
(72) Inventeur: Barrey, Stéphane, 45530 Vitry Aux Loges (FR); Belnoue, Olivier, 45390 Puiseaux (FR)
(74) Mandataire: Breese Derambure Majerowicz

(57) **Abrégé**

La présente invention se rapporte au domaine des circuits imprimés.

La présente invention se rapporte à un procédé de fabrication d'un circuit imprimé de dissipation thermique par stratification d'au moins une couche conductrice (1), un substrat isolant (2) et un substrat métallique (3) de dissipation thermique, caractérisé en ce que ledit substrat isolant (2) est déposé de façon sélective sur ledit substrat métallique (3) par dépôt de substrat isolant uniquement sur les zones où le dépôt est souhaité.

## Description

La présente invention se rapporte au domaine des circuits imprimés.

La présente invention concerne plus particulièrement un procédé de fabrication d'un circuit imprimé de dissipation thermique mettant en oeuvre un dépôt sélectif du substrat isolant afin d'améliorer la dissipation thermique des composants.

L'art antérieur connaît déjà un procédé de fabrication de circuits imprimés par stratification proposant une dissipation thermique de la chaleur émise par les différents composants. De tels circuits intègrent un substrat métallique ayant de bonnes propriétés dissipatrices d'énergie. Dans la pratique, le substrat métallique est en aluminium, en cuivre ou en acier. Le circuit est composé d'une couche isolante qui, associée au substrat métallique, forme un puit thermique, et d'une couche conductrice, généralement de cuivre. Ce procédé s'applique également aux circuits imprimés multicouches.
Devant l'augmentation de la puissance des composants et donc devant l'accroissement de l'énergie à évacuer, les industriels ont mis en oeuvre des procédés d'amélioration des circuits imprimés de dissipation thermique traditionnels en enlevant mécaniquement les surplus de couches conductrice et isolante du circuit afin d'intégrer les composants directement en contact avec le substrat métallique. Dans la pratique, les procédés utilisés sont abrasifs, par exemple par fraisage.

L'art antérieur connaît également, par les brevets US 5 670 750, US 4 999 740 et JP 07 263838, un procédé de dépôt d'un substrat isolant par voie soustractive, c'est-à-dire en déposant le substrat sur l'ensemble de la zone et en retirant ensuite les zones non désirées par un procédé photosensible, par exemple. Le désavantage de ce procédé par voie soustractive est de nécessiter, suite au dépôt de la résine, des étapes supplémentaires pour la retirer partiellement.

On connaît également, par la demande de brevet JP 03 222352, un procédé de fabrication d'un circuit intégré hybride présentant des zones de mise en contact direct d'un composant avec un substrat métallique. Pour autant, ce document n'indique pas comment procéder pour réaliser ce dépôt sélectif, notamment s'il utilise la voie additive par sérigraphie, solution économique.
Egalement, la demande de brevet JP 61 287152 décrit un procédé de fabrication d'un circuit imprimé dans lequel un substrat isolant (6) muni d'un trou traversant est laminé tel quel sur une base métallique (1) par l'intermédiaire d'une couche adhésive isolante (7). La couche adhésive isolant n'est clairement pas déposée de façon sélective.
On connaît également le brevet US 6 428 189 qui ne réalise pas une stratification par dépôt d'une couche isolant sur un substrat métallique et le brevet US 4 993 148 fournissant une solution dont les composants sont isolés du substrat métallique par une couche (référence 6 de la figure de l'abrégé du brevet US 4 993 148), ce qui diminue fortement l'efficacité dissipatrice de l'ensemble.

La présente invention entend remédier aux inconvénients de l'art antérieur en proposant un procédé de fabrication d'un circuit imprimé de dissipation thermique mettant en oeuvre un dépôt sélectif par voie additive de la couche isolante sur le substrat métallique de dissipation thermique.

Le procédé selon la présente invention répond particulièrement bien aux attentes futures des utilisateurs de circuits imprimés quant à l'élimination de la chaleur émise par les composants d'un circuit imprimé. On peut noter, entre autres, les équipementiers automobiles qui intègrent désormais un nombre croissant de diodes électroluminescentes. Ces diodes dont la puissance (plusieurs watts), le rendement et la luminosité sont élevés dissipent une forte quantité de chaleur. Les nouveaux circuits imprimés se doivent désormais d'accroître leurs capacités de dissipation thermique.

A cet effet, l'invention concerne dans son acceptation la plus générale un procédé de fabrication d'un circuit imprimé de dissipation thermique par stratification d'au moins une couche conductrice C, un substrat isolant I et un substrat métallique M de dissipation thermique, caractérisé en ce que ledit substrat isolant I est déposé de façon sélective sur ledit substrat métallique M par dépôt de substrat isolant uniquement sur les zones où le dépôt est souhaité.

Dans un mode de réalisation, le dépôt sélectif dudit substrat isolant sur ledit substrat métallique est réalisé par sérigraphie.
Dans un mode de réalisation particulier, une fine couche isolante est déposée sur au moins une des zones où ledit substrat isolant n'a pas été déposé de façon sélective, cette fine couche isolante pouvant être une encre thermiquement conductrice et électriquement isolante.

Selon un mode de mise en oeuvre, une diode électroluminescente ou un composant de puissance est fixé sur au moins une des zones dudit substrat métallique où ledit substrat isolant n'a pas été déposé de façon sélective.

Particulièrement, ledit circuit imprimé est multicouches par itération d'un dépôt sélectif d'au moins une couche de substrat isolant et d'une couche conductrice sur ladite couche conductrice C.

Selon le mode de réalisation choisi, ledit substrat métallique est un alliage à base d'aluminium, est en aluminium, un alliage à base de cuivre, est en cuivre ou est un circuit imprimé de dissipation thermique.
Eventuellement, le procédé comprend, en outre, une étape de dépôt par sérigraphie d'un isolant électrique sur la face externe dudit substrat métallique.

L'invention concerne également un circuit imprimé de dissipation thermique comprenant une couche conductrice, un substrat métallique de dissipation thermique et un substrat isolant déposé sélectivement sur ledit substrat métallique, caractérisé en ce que les bords des zones du substrat isolant présentent une déviation par rapport à une ligne médiane inférieure à 0,5 mm.
Particulièrement, les bords des zones du substrat isolant présentent une déviation par rapport à une ligne médiane inférieure à 0,1 mm.

L'invention concerne également un circuit imprimé de dissipation thermique comprenant une couche conductrice, un substrat métallique de dissipation thermique et un substrat isolant déposé sélectivement sur ledit substrat métallique, caractérisé en ce que la surface du substrat métallique présente dans les zones non recouvertes par le substrat isolant est plane et dépourvue de résidu de substrat isolant et de trace d'usinage.

On comprendra mieux l'invention à l'aide de la description, faite ci-après à titre purement explicatif, d'un mode de réalisation de l'invention, en référence aux figures annexées où :
- la figure 1 représente une vue stratifiée du circuit imprimé,
- la figure 2 représente une coupe du circuit imprimé selon la présente invention mettant en oeuvre une diode électroluminescente,
- les figures 3 et 4 représentent deux réalisations possibles de circuit imprimé multicouches selon la présente invention,
- la figure 5 représente une vue en coupe d'un circuit obtenu par un procédé de l'art antérieur, et
- la figure 6 représente une réalisation de l'invention assurant l'isolation électrique des composants.

La présente invention met en oeuvre un procédé de fabrication d'un circuit imprimé de dissipation thermique.
L'intérêt du procédé de la présente invention est de réaliser un circuit imprimé à faibles coûts, en utilisant les procédés techniques connus, en offrant un circuit ayant de fortes capacités de dissipation thermique au niveau où les composants sont intégrés. Le marché visé concerne principalement le domaine des diodes électroluminescentes (DEL) et tout composant de puissante présentant un fort dégagement de chaleur nécessitant un refroidissement. En effet, pour certains types de DEL, la puissance atteint plusieurs watts, et la dissipation d'énergie se fait uniquement par chaleur.

Afin de faciliter la compréhension des explications, la description qui suit se cantonne à un circuit imprimé simple couche. Cependant, il est évident que la présente invention ne se limite pas aux circuits imprimés simple couche, mais que le procédé selon la présente invention s'applique tout aussi bien pour la fabrication de circuits imprimés multicouches. On entend par circuit imprimé, toute plaque de circuit imprimé que les pistes soient gravées/imprimées ou non.

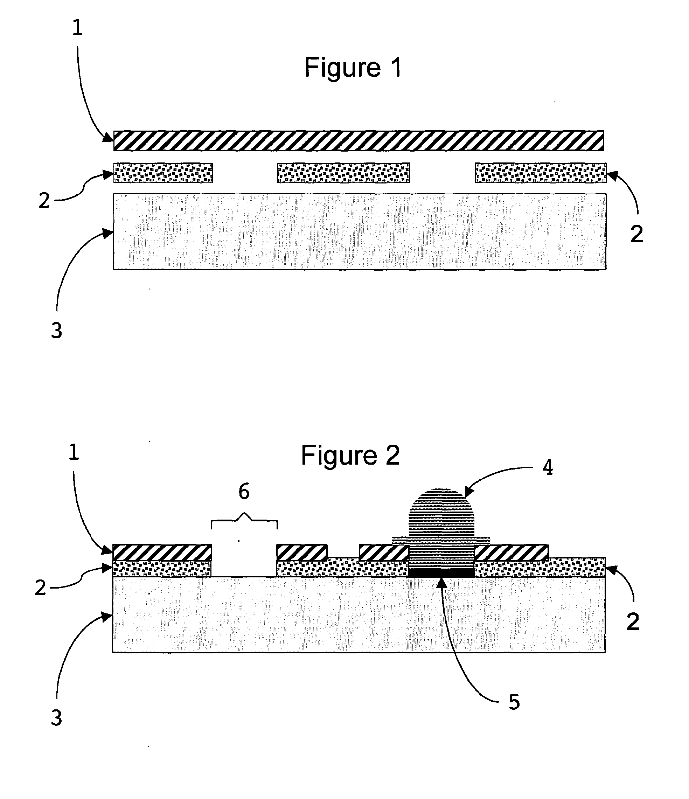

En référence à la figure 1, la fabrication d'un circuit imprimé de dissipation thermique par stratification met en oeuvre un substrat métallique (3), une couche isolante (2) et une couche conductrice (1).
Dans la pratique, le substrat métallique (3) est une plaque d'aluminium ou de cuivre ou un alliage à base d'aluminium ou de cuivre, mais peut tout aussi bien être constitué d'un autre matériau thermiquement conducteur. Son rôle est de dissiper l'énergie dégagée sous forme de chaleur par les composants intégrés au circuit. De plus, il participe à la rigidité de la structure. Son épaisseur est d'environ un à quelques millimètres.
La couche isolante (2) peut être, par exemple, en verre époxy, ou une encre époxy ou acrylique.
La couche conductrice (1) est habituellement un feuillard de cuivre dont l'épaisseur peut varier de 30 à 200 µm. Dans un mode de réalisation préféré, l'épaisseur du feuillard de cuivre est 35 µm.

Le procédé selon la présente invention consiste donc à déposer de façon sélective la couche isolante ou substrat isolant (2) sur le substrat métallique (1). Dans le produit résultant du procédé selon la présente invention, en référence à la figure 2, les zones où le substrat isolant (2) a été déposé sont plus isolées thermiquement que les zones où le substrat isolant n'a pas été déposé, par exemple sur la zone où a été intégrée la DEL (4).

Dans un mode de réalisation, on réalise un masque où les parties évidées correspondent aux zones où l'on désire déposer le substrat isolant et les parties « pleines » aux zones où le dépôt n'est pas effectif. Le masque peut être réalisé par un procédé photographique. De préférence, le masque est un pochoir. Il est alors positionné sur le substrat métallique. Le substrat isolant (2) est ensuite déposé par sérigraphie sur l'ensemble composé du substrat métallique et du pochoir. Au retrait du pochoir, seules les zones correspondant aux zones évidées du pochoir auront reçu un dépôt de substrat isolant (2). Il s'agit d'un dépôt par voie additive (à l'opposé, la voie soustractive requiert un dépôt de résine sur l'ensemble de la plaque 3 puis un retrait de celle-ci sur les parties non souhaitées).
La résine 2 ainsi déposée sélectivement peut être partiellement polymérisée, par exemple par augmentation de température dans le cas d'une résine thermiquement polymérisable.
Le feuillard de cuivre (1) est positionné sur le diélectrique (association du substrat métallique avec le substrat isolant) ainsi obtenu. L'ensemble est pressé à chaud, assurant du fait de la température et de la pression, une polymérisation de la résine et une adhésion entre le feuillard de cuivre 1 et la résine 2.

Selon un autre mode de réalisation, le substrat isolant se compose d'une plaque, par exemple de verre d'époxy. Cette plaque est usinée, par exemple par perçage, de telle sorte que les zones où le dépôt de substrat isolant ne doit pas être effectué soient évidées. Ces zones sont des lumières dans la plaque.
La plaque ainsi usinée est déposée sur le substrat métallique et le feuillard de cuivre déposé sur la plaque.

Les procédés traditionnels de fabrication de circuits imprimés par stratification sont mis en oeuvre pour terminer le circuit, à savoir, le pressage thermique, l'inscription des pistes conductrices, puis le dépôt d'un vernis isolant sur le dessus du circuit.

Le circuit ainsi obtenu présente, en référence à la figure 2, présente des zones (6) sur lesquelles les composants (4) peuvent être intégrés en contact direct avec le substrat métallique.

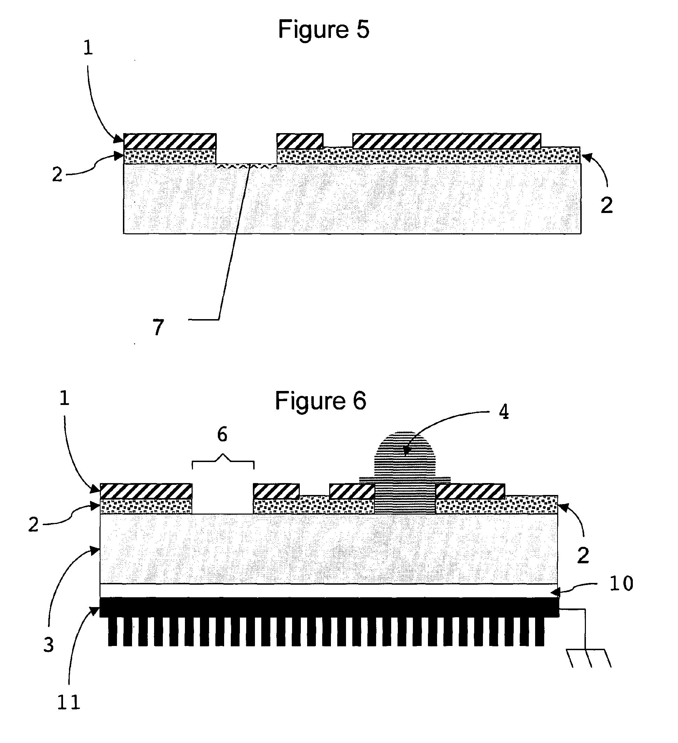

Dans un mode de réalisation, le substrat métallique présente un potentiel électrique non neutre. Afin de diminuer son interaction avec les composants intégrés dans les zones (6), une fine pellicule isolante (5) de quelques microns d'épaisseur est déposée par sérigraphie. Cette substance isolante peut être une encre, une résine, une colle ou un adhésif. De préférence, on utilise une encre époxy ou acrylique.
Cette encre doit proposer une faible isolation électrique mais suffisante pour que l'effet du potentiel du substrat métallique ne se fasse ressentir au niveau des composants, et une bonne conduction thermique pour conserver les avantages procurés par le procédé de la présente invention.
Dans un autre mode de réalisation illustré par la figure 6, une fine couche 10 d'isolant électrique (vernis ou résine) peut être déposée par sérigraphie sur la face externe du substrat métallique 3. Cette couche permet efficacement d'isoler électriquement la DEL 4 d'un radiateur 11 connecté à la masse et qui peut être placé contre le substrat 3. Ainsi la DEL ou le composant de puissance 4 est protégé contre des décharges électrostatiques pouvant l'endommager. Cette solution présente un bon compromis entre isolation électrique de l'ensemble et dissipation thermique du composant 4.
Afin d'améliorer la dissipation thermique de l'ensemble, le substrat 3 peut être mis en contact avec un radiateur 11 (figure 6) ou un vecteur de dissipation assurant l'échange d'énergie par convection.

Dans un mode de réalisation particulièrement avantageux, des diodes électroluminescentes DEL (4) qui atteignent maintenant plusieurs watts de puissance, sont intégrées dans les zones évidées par le procédé de la présente invention. Le cul de la DEL est directement posé sur la fine pellicule d'encre. L'énergie émise par la diode passe directement du cul de la DEL au substrat métallique, pour être dissipée.

Le procédé selon la présente invention permet ainsi de réaliser aisément des formes complexes du substrat isolant, ces formes ayant une régularité que les procédés de l'art antérieur n'offrent pas. En effet, pour un triangle, le procédé de l'invention permet d'obtenir des angles « pointus » alors que, précédemment, ceux-ci présentaient des rayures dues à l'usinage.

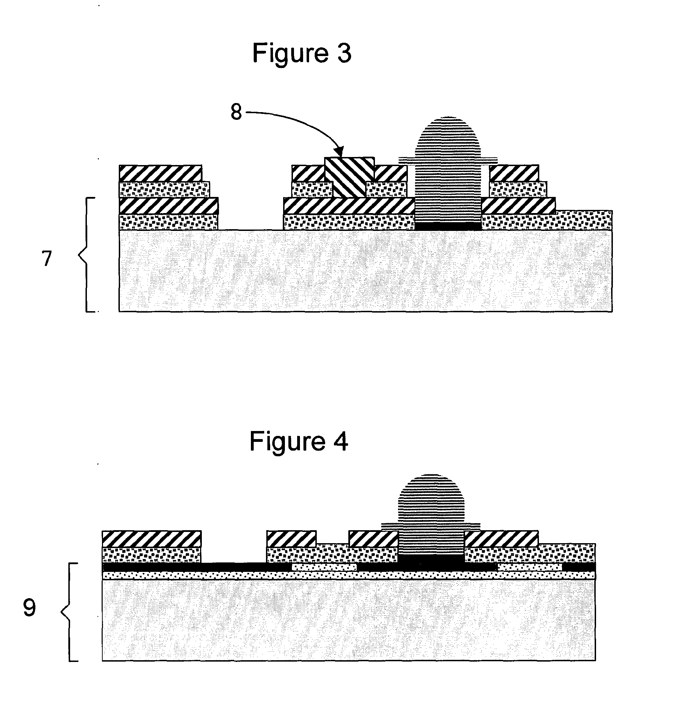

En référence à la figure 3, dans un mode de réalisation alternatif, le procédé selon la présente invention est appliqué au moins une fois à un circuit imprimé (7) crée par le procédé selon la présente invention de sorte à constituer un circuit imprimé multicouches de dissipation thermique. Le circuit imprimé obtenu est ensuite modifié par les techniques connues pour assurer la liaison électrique (8) entre les différentes couches conductrices et intégrer les composants.
Ce mode de réalisation effectue une répétition des opérations de stratification par dépôt sélectif, les liaisons électriques entre les différentes couches de l'ensemble constitué, étant réalisées par le dépôt d'une pâte polymère conductrice (8) dans des trous prévus lors du dépôt sélectif des couches.

La présente invention s'applique également, en référence à la figure 4, à des circuits imprimés simple couche ou multicouches du commerce (9) de sorte à obtenir des circuits imprimés multicouches. L'effet recherché étant toujours d'améliorer la dissipation thermique des composants qui seront intégrés dans les zones sans dépôt du substrat isolant.

La figure 5 représente un circuit obtenu par un procédé de l'art antérieur où le circuit présente des traces d'usinage (7) et une rugosité sur la surface du substrat métallique ainsi que sur les bords du substrat isolant entourant la zone ajourée.

## Revendications

1. Procédé de fabrication d'un circuit imprimé de dissipation thermique par stratification d'au moins une couche conductrice C, un substrat isolant I et un substrat métallique M de dissipation thermique, **caractérisé en ce que** ledit substrat isolant I est déposé de façon sélective sur ledit substrat métallique M par dépôt de substrat isolant uniquement sur les zones où le dépôt est souhaité.

2. Procédé de fabrication d'un circuit imprimé de dissipation thermique selon la revendication 1, **caractérisé en ce que** le dépôt sélectif dudit substrat isolant I sur ledit substrat métallique M est réalisé par sérigraphie.

3. Procédé de fabrication d'un circuit imprimé de dissipation thermique selon les revendications précédentes, **caractérisé en ce qu'**une fine couche isolante E est déposée sur au moins une des zones où ledit substrat isolant I n'a pas été déposé de façon sélective.

4. Procédé de fabrication d'un circuit imprimé de dissipation thermique selon la revendication précédente, **caractérise en ce que** ladite fine couche isolante E est une encre thermiquement conductrice et électriquement isolante.

5. Procédé de fabrication d'un circuit imprimé de dissipation thermique selon l'une quelconque des revendications précédentes, **caractérisé en ce qu'**un composant de puissance est fixé sur au moins une des zones dudit substrat métallique M où ledit substrat isolant I n'a pas été déposé de façon sélective.

6. Procédé de fabrication d'un circuit imprimé de dissipation thermique selon l'une quelconque des revendications précédentes, **caractérisé en ce que** ledit circuit imprimé est multicouches par itération d'un dépôt sélectif d'au moins une couche de substrat isolant et d'une couche conductrice sur ladite couche conductrice C.

7. Procédé de fabrication d'un circuit imprimé de dissipation thermique selon l'une quelconque des revendications précédentes, **caractérisé en ce que** ledit substrat métallique M comprend de l'aluminium.

8. Procédé de fabrication d'un circuit imprimé de dissipation thermique selon l'une quelconque des revendications 1 à 6, **caractérisé en ce que** ledit substrat métallique M comprend du cuivre.

9. Procédé de fabrication d'un circuit imprimé de dissipation thermique selon l'une quelconque des revendications 1 à 6, **caractérisé en ce que** ledit substrat métallique M est un circuit imprimé de dissipation thermique.

10. Procédé de fabrication d'un circuit imprimé de dissipation thermique selon l'une quelconque des revendications précédentes, **caractérisé en ce qu'**il comprend, en outre, une étape de dépôt par sérigraphie d'un isolant électrique (10) sur la face externe dudit substrat métallique (3).

11. Circuit imprimé de dissipation thermique comprenant une couche conductrice, un substrat métallique de dissipation thermique et un substrat isolant déposé sélectivement selon l'une quelconque des revendications précédentes sur ledit substrat métallique, **caractérisé en ce que** les bords des zones du substrat isolant présentent une déviation par rapport à une ligne médiane inférieure à 0,5 mm.

12. Circuit imprimé de dissipation thermique selon la revendication 11, **caractérisé en ce que** les bords des zones du substrat isolant présentent une déviation par rapport à une ligne médiane inférieure à 0,1 mm.

13. Circuit imprimé de dissipation thermique comprenant une couche conductrice, un substrat métallique de dissipation thermique et un substrat isolant déposé sélectivement selon l'une quelconque des revendications 1 à 10 sur ledit substrat métallique, **caractérisé en ce que** la surface du substrat métallique présente dans les zones non recouvertes par le substrat isolant est plane et dépourvue de résidu de substrat isolant et de trace d'usinage.
